Europäisches Patentamt

European Patent Office

Office européen des brevets

(19)

(11) Publication number: **0 258 149**
**A2**

# (12) EUROPEAN PATENT APPLICATION

(21) Application number: **87401928.4**

(22) Date of filing: **25.08.87**

(51) Int. Cl.⁴: **H 01 L 29/72**
**H 01 L 29/08**

(30) Priority: **29.08.86 US 902369**

(43) Date of publication of application:
**02.03.88 Bulletin 88/09**

(84) Designated Contracting States: **DE FR GB IT NL**

(71) Applicant: **FAIRCHILD SEMICONDUCTOR CORPORATION**
**10400 Ridgeview Court P.O. Box 1500**
**Cupertino California 95014 (US)**

(72) Inventor: **Jerome, Rick C.**
**1111 - 39th Avenue S.E.**
**Puyallup Washington 98374 (US)**

(74) Representative: **Chareyron, Lucien et al**
**SCHLUMBERGER LIMITED Service Brevets 12, place des Etats Unis B.P. 121**
**F-92124 Montrouge Cedex (FR)**

(54) Low dose emitter vertical fuse.

(57) A vertical fuse structure is disclosed which includes a lightly-doped emitter 30 to provide improved fusing characteristics. The structure includes a buried collector 12, an overlying base 18, and an emitter 30 above the base 18. In the preferred embodiment, the emitter 30 extends approximately 0.2 microns from the upper surface and has an impurity concentration of about $8 \times 10^{19}$ atoms of arsenic per cubic centimeter at the surface. The base region 18 is lightly doped and extends for approximately 0.46 microns below the emitter 30 to the collector 12. On the upper surface of emitter 30, a metal contact 35 is disposed. The fuse is blown by heating the metal 35 emitter 30 interface to its eutectic melting point using a current or voltage pulse to cause the aluminum to short through the emitter 30 to the base 18.

FIG.—I.

EP 0 258 149 A2

**Description**

LOW DOSE EMITTER VERTICAL FUSE

BACKGROUND OF THE INVENTION

Field of the Invention

This invention relates to the fabrication of transistors and fuses in bipolar integrated circuits. In particular, the invention relates to a bipolar vertical fuse in which a low dose arsenic emitter in a thin epitaxial layer provides the fuse.

Description of the Prior Art

Numerous processes are now well known for the fabrication of bipolar integrated circuits. Oxide isolated bipolar integrated circuits are also well known, for example, as taught by Douglas Peltzer in U.S. Patent 3,648,125, entitled "Method of Fabricating Integrated Circuits with Oxidized Isolation and the Resulting Structure." In typical oxide isolated processes, an N type buried layer is diffused into a P type silicon substrate. An N type epitaxial layer is then deposited across the upper surface of the substrate. A suitable mask, typically silicon nitride on silicon dioxide, then is formed on top of the epitaxial layer, with regions of the silicon nitride being removed wherever field oxide regions are desired in the epitaxial layer. The epitaxial layer then is oxidized through the openings in the nitride layer to define these field oxide regions. If a recessed field oxide region is desired, a silicon etch is performed prior to oxidation.

In conventional bipolar process technology, the epitaxial layer is then implanted with P type impurity to define the base of the bipolar device, and then a heavily doped N-type emitter diffused within the base region. If a transistor is desired, metal contacts are formed to the emitter, base and collector. The base contact is spaced apart from the emitter contact, while the collector contact relies upon a collector sink of like conductivity type to the buried layer, extending from the surface of the epitaxial layer to the buried layer. If a fuse is to be formed, the base contact is omitted.

In the prior art, such bipolar devices have been employed as fuses in programmable read only memories (PROMs) and in programmed array logic devices (PALS), as well as in other types of circuits. The fusing action in such circuits is activated by supplying a sufficiently high current or voltage pulse between the emitter and collector contacts to heat the metal/silicon interface of the emitter contact sufficiently to cause the silicon to dissolve in the metal. The metal then backfills into the void spiking through the emitter to the base. The spike alters the operational characteristics of the device and is readily detectable during subsequent operations. In a memory, the spike transforms the bit from a "0" to a "1" storage element. Unfortunately, such prior art fuses rely upon a relatively thick epitaxial layer and an additional boron heavy implant of the base. The result is higher programming currents, a high collector-base capacitance, and undesirably slow switching speeds. In addition, such prior art devices are vulnerable to overblowing by which the metal contact shorts completely through the base to the collector and forms a Schottky diode. Prior art fuses are also more susceptible to word-line crosstalk.

Another disadvantage of such prior art fuses is the relatively thick epitaxial layer required for their fabrication. Thinner epitaxial layers allow faster circuit operation and thinner field oxide, thereby lessening the stress on the silicon crystal and lowering junction leakage. Still another disadvantage of many prior art vertical fuses is their use of diffused emitters. This results in larger volume and correspondingly higher programming current.

SUMMARY OF THE INVENTION

I have developed a process and semiconductor structure for a vertical fuse which reduces programming power and is more reliable than prior art fuses. The fuse of my invention is adaptable for use with relatively thin epitaxial layers, and maintains a low collector-base capacitance, thereby enabling faster switching speeds. The wider base width of the structure of my invention helps prevent overblowing, while the implanted emitter is more controllable and reliable.

In a preferred embodiment my vertical fuse structure includes a buried N conductivity type collector region under an N-epitaxial region, an overlying P conductivity type base region simultaneously formed with high-current gain NPN transistors, and a lightly doped emitter region formed in the base region, all using the same number of masking operations as the prior art fuse. The emitter extends to the surface of the wafer and has an impurity concentration of less than about $8 \times 10^{19}$ atoms of arsenic per cubic centimeter at the surface. The resulting fuse blows at a lower current and is adaptable for thin epitaxial layers. It may be readily implemented with larger emitter areas for higher resistance to solid phase epitaxial growth. The unprogrammed fuse is resistant to spiking during heat treatments used in fabricating the integrated circuit structure.

BRIEF DESCRIPTION OF THE DRAWINGS

Figure 1 is a cross-sectional view of a preferred embodiment of the vertical fuse;

Figure 2 is a schematic illustrating an array of fuses before any are blown;

Figure 3 is a diagram illustrating the impurity concentration versus depth within the structure of Figure 1;

Figure 4 is a cross section of the programmed fuse showing a shorted emitter/base junction; and

Figure 5 is a schematic illustrating an array of fuses after selected ones have been blown.

## DETAILED DESCRIPTION OF THE PREFERRED EMBODIMENT

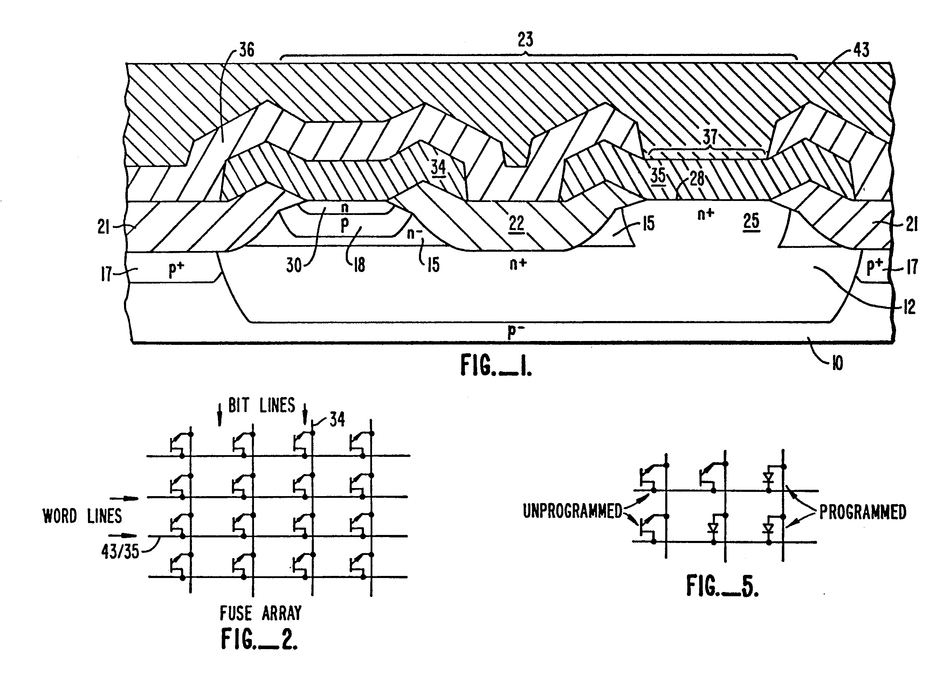

Figure 1 is a cross-sectional view of a semiconductor structure which includes a P conductivity type silicon substrate 10 doped with boron to a resistivity of 1 to 3.5 ohms•cm. A buried layer 12 extends into substrate 10 and is doped with antimony to a peak concentration of approximately $3 \times 10^{19}$ atoms per cubic centimeter. Over the upper surface of the substrate 10 and buried layer 12 a thin epitaxial layer 15 is deposited, also of monocrystalline silicon. In the preferred embodiment, epitaxial layer 15 is approximately 1.1 microns thick and doped with phosphorus to a concentration of $1 \times 10^{16}$ atoms per cubic centimeter. A channel stop implant 17 is introduced prior to the epitaxial layer deposition in regions where field oxide will be formed to prevent channel inversion at the silicon dioxide/silicon interface. As described in the Peltzer patent, regions of epitaxial silicon 15 are masked with silicon nitride, and a silicon etch is performed. Next, a high temperature oxidation is used to create fully recessed field oxide regions 21 and 22. In the preferred embodiment, region 21 is annular and surrounds an island 23 of epitaxial silicon 15, to thereby provide an electrically-isolated pocket within which active and/or passive devices may be formed. Another portion of field oxide 22 separates a collector sink 25 from the remainder of the to-be-formed transistor.

After formation of the field oxide regions 21 and 22, the collector sink 25 is heavily doped with N type impurity, typically phosphorus, to thereby provide a connection between surface 28 and buried layer 12. Because buried layer 12 is the collector of the bipolar transistor, a connection to collector sink 25 at surface 28 is a collector contact for the transistor. The base is implanted with P-type impurity and has a concentration of about $2 \times 10^{18}$ atoms per cubic centimeter at a depth of 0.22 microns. As a final step in manufacture of the substrate structure, the emitter 30 is doped. The transistor thereby created has emitter 30, base 15 and collector 12. On the upper surface 28 of the structure, a first layer of metal contacts 34 and 35 are deposited and defined using well known photolithographic techniques. Metal lines 34 provide the bit lines for the array and extend perpendicular to the plane of the drawing of Figure 1.

An intermediate dielectric 36 is next deposited over the first layer metal, and using well known techniques, via openings 37 are provided. Then a second metal layer 43 is deposited and defined to provide word lines for the array. Contact 35 to the collector sink 25 provides a connection to the fuse for the word line 43 which extends perpendicular to the bit line 34 in the same plane as the bit lines.

In the preferred embodiment of my invention, the base region is completely surrounded by silicon dioxide field regions 21 and 22. The emitter 30 is doped with arsenic and has an electrically active impurity concentration of $3 \times 10^{19}$ atoms per cubic centimeter at its upper surface 28, and a total chemical impurity concentration of $8 \times 10^{19}$ atoms per cubic centimeter. The emitter is approximately 0.21 microns deep, while the metal contacts 35 are comprised of 4%. copper and 0.9%. silicon, by weight, with about 95.1% aluminum. The lower doping of the emitter 30 is critical to my invention and, as discussed, provides several advantages with respect to prior art fuses.

Figure 2 is a schematic diagram illustrating how an array of the individual fuses of Figure 1 is interconnected. Each fuse structure of Figure 1 occupies one position in the array of Figure 2 and includes connections to both a bit line 34 and a word line 43. Because each fuse consists of a floating base NPN transistor, no connection is needed to the base region.

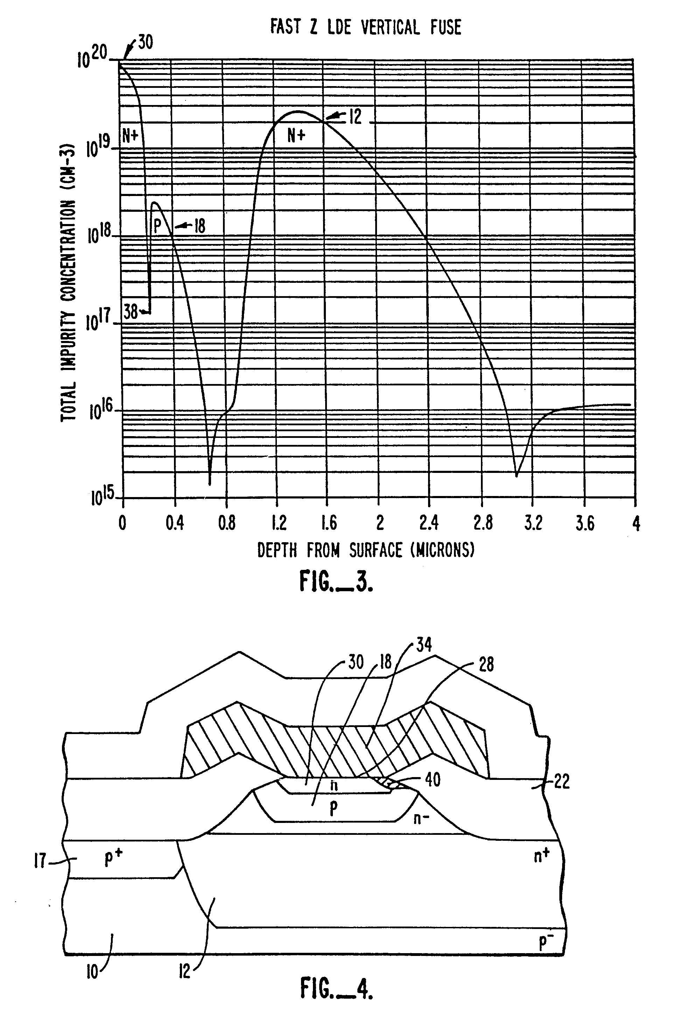

Figure 3 is a graph illustrating the relationship of impurity concentration as a function of depth below the silicon surface 28 through the emitter 30, base 18, collector 12, and substrate 10. As shown, at the surface 28 of emitter 30, the arsenic impurity predominates with a chemical concentration of approximately $8 \times 10^{19}$ atoms per cubic centimeter. At the emitter-base junction 38, the emitter concentration has fallen to less than $2 \times 10^{17}$ atoms per cubic centimeter. The P type base impurity dominates the N type emitter impurity from approximately 0.21 microns into the structure to approximately 0.67 microns. The maximum doping for the base is approximately $2 \times 10^{18}$ atoms per cubic centimeter at a depth of about 0.22 microns. At about 0.67 microns into the structure, the impurity concentration of collector 12 dominates. This reflects the upward diffusion of the collector impurity into the epitaxial layer by about 0.3 microns during the oxidation process used to form field oxide regions 21 and 22. The collector impurity continues to dominate to a depth of about 3 microns when the impurity for the substrate 10 is reached. Approximately 0.15 microns of N-epi lies under the base, prior to the upward diffusion of the N+ buried layer.

Figure 4 is a cross section of the emitter 30, base 18, and buried layer 12 illustrating the fusing action of the structure of Figure 1. Prior to blowing the fuse, the structure of Figure 1, using the dimensions and impurity concentration specified, has an emitter-collector breakdown voltage of approximately 3.5 volts and a collector-emitter breakdown voltage of about 19 volts. Programming the structure is accomplished by applying current or voltage pulse to the emitter in an emitter-collector breakdown mode. For programming, the current will be about 45 milliamps for approximately 2.7 microseconds, with a resulting energy of 1.35 microJoules and a power of about 360 milliWatts. In the preferred embodiment, this pulse will be a ramped pulse from 0 to 6.3 volts in about 500 nanoseconds. As a result of the pulse, the interface between metal 34 and silicon 30 is heated to its eutectic melting point of about 555° C, allowing the silicon to rapidly dissolve into the metal, leaving behind a void which mass transport of the metal fills. The result is a spike 40 which extends through the emitter-base junction 38 to short metal contact 35 to base 18. The pulse is discontinued when a voltage drop is detected. After programming, the collector-base breakdown voltage will be about 24 volts. At 100 microamps the forward voltage will be 0.87 volts, and the series resistance will be 115 ohms.

Figure 5 is a schematic illustrating an array of fuses, some of which have been programmed. The unprogrammed fuses are represented as floating base transistors while the programmed fuses are shown as collector-base diodes. Appropriate well known circuitry coupled to the word and bit lines of the array in Figure 5 will detect the programmed and unprogrammed fuses. This circuitry can then interpret and supply to other circuitry suitable signals indicative of the "1" or "0" detected.

The vertical fuse of my invention is particularly advantageous because it employs a low dose emitter without P type enhancement to thereby provide lower programming currents, higher collector-emitter and collector-base breakdown voltage, and lower collector-base capacitance. By virtue of the lightly doped shallow emitter, the emitter has a small volume so only a low programming current is required. The lower power allows faster programming, an important advantage for large arrays. In tests, heat treatments of 450°C for 60 minutes show no evidence of causing the aluminum contact 35 to prematurely cause a spike through the shallow emitter 30. The wider base width helps prevent overblowing the fuse. Life tests of programmed fuses at 200°C for 9 days does not cause any appreciable increase in series resistance.

The implanted emitter on the fuse of my invention is more controllable and reliable than the diffused emitters of the prior art. The implantation of the emitter with a light dose of impurity increases the emitter resistance and helps retain heat near the metal/silicon interface, facilitating lower programming power. Additionally, because of lower emitter injection efficiency and lower base transport factor, my fuse displays higher $BV_{eco}$ and $BV_{ceo}$ than the prior art. The higher voltages prevent unwanted parasitic leakage between adjacent word lines within an array.

In the foregoing description of the invention, numerous details have been provided to explain the invention and describe an exemplary embodiment. The scope of the invention may be ascertained from the appended claims.

## Claims

1. A vertical fuse semiconductor structure comprising:

a buried N conductivity type collector region;

an overlying P conductivity type base region; and

an emitter region formed in the base region and extending to a surface, the emitter having an active chemical impurity concentration of less than about $8 \times 10^{19}$ atoms of arsenic per cubic centimeter at the surface.

2. A fuse as in Claim 1 wherein the impurity concentration of the emitter is between $3 \times 10^{19}$ and $8 \times 10^{19}$ atoms per cubic centimeter at the surface.

3. A fuse as in Claim 2 wherein the emitter region has an electrically active impurity concentration of about $3 \times 10^{19}$ atoms per cubic centimeter at the surface.

4. A fuse as in Claim 1 wherein the emitter region is surrounded by silicon dioxide.

5. A fuse as in Claim 1 further comprising a metal contact to the surface of the emitter.

6. A fuse as in Claim 5 wherein the metal contact comprises aluminum and silicon.

7. A fuse as in Claim 6 wherein the metal contact further comprises copper.

8. A fuse as in Claim 7 wherein the metal contact comprises approximately 1% silicon and 4% copper.

9. A fuse as in Claim 1 wherein the emitter extends approximately 0.2 microns into the base and the base is approximately 0.45 microns thick.

10. A vertical fuse semiconductor structure comprising:

a buried N conductivity type collector region;

an overlying P conductivity type base region surrounded by silicon dioxide and extending approximately 0.45 microns above the collector region;

an emitter region formed atop the base region and extending to a surface, the emitter having an impurity concentration of less than about $8 \times 10^{19}$ atoms of arsenic per cubic centimeter at the surface and extending approximately 0.2 microns to the base region; and

an electrical contact deposited on the surface of the emitter region comprising approximately 95% aluminum, 4% copper, and 1% silicon.

FIG.—1.

BIT LINES

WORD LINES

43/35

34

FUSE ARRAY

FIG.—2.

UNPROGRAMMED

PROGRAMMED

FIG.—5.

0258149

FAST Z LDE VERTICAL FUSE

FIG.—3.

FIG.—4.